# EUROPEAN PATENT SPECIFICATION

(11) **EP 4 175 012 B1**
(45) Date of publication and mention of the grant of the patent: **02.12.2026**
(21) Application number: 21832253.5
(22) Date of filing: 20.05.2021
(51) Int. Cl.: G01R 31/374, G01R 31/3842, H02J 7/65, H02J 7/94, H02J 7/96, H02J 7/90, G01R 31/367, G01R 31/392, H01M 10/0525, H01M 10/42, H01M 10/48

(54) **POWER SUPPLY DEVICE AND METHOD FOR DETECTING DEFECTS IN BATTERY**
STROMVERSORGUNGSVORRICHTUNG UND VERFAHREN ZUR ERKENNUNG VON BATTERIEDEFEKTEN
DISPOSITIF D'ALIMENTATION ÉLECTRIQUE ET PROCÉDÉ DE DÉTECTION D'EFFETS DANS UNE BATTERIE

(30) Priority: 29.06.2020 JP 2020112016
(43) Date of publication of application: 03.05.2023
(73) Proprietor: Murata Manufacturing Co., Ltd., Nagaokakyo-shi, Kyoto 617-8555 (JP)
(72) Inventor: SHIMURA, Jusuke, Nagaokakyo-shi, Kyoto 617-8555 (JP); KAMITANI, Gaku, Nagaokakyo-shi, Kyoto 617-8555 (JP)
(74) Representative: Witte, Weller & Partner Patentanwälte mbB
(86) International application number: PCT/JP2021/019193
(87) International publication number: WO 2022/004185

(56) References cited:
- EP-B1- 3 092 144
- WO-A1-2019/156171
- WO-A1-99/63613
- JP-A- 2010 066 161
- JP-A- 2010 272 365
- JP-A- 2012 003 863
- JP-A- 2014 206 441
- JP-A- 2018 096 744
- JP-A- 2018 096 744
- JP-A- 2019 050 168
- JP-A- H0 917 458
- US-A1- 2010 004 885
- US-A1- 2010 194 398
- US-A1- 2015 244 165
- US-A1- 2020 044 294
- XIA BING ET AL: "External short circuit fault diagnosis for lithium-ion batteries", 2014 IEEE TRANSPORTATION ELECTRIFICATION CONFERENCE AND EXPO (ITEC), IEEE, 15 June 2014 (2014-06-15), pages 1 - 7, XP032778649, DOI: 10.1109/ITEC.2014.6861806

## Description

### TECHNICAL FIELD

The present invention relates to a power supply device and a failure detection method for a battery.

### BACKGROUND ART

Conventionally, a technique for detecting a failure of a lithium ion battery by measuring a voltage or a current of the lithium ion battery has been studied. For example, Patent Document 1 proposes a power supply device including: a voltage detection unit that detects the voltage between positive and negative terminals of the lithium ion battery; and a battery abnormality determination unit that determines occurrence of a micro-short circuit in which a detection value of the voltage detection unit instantaneously drops, and determines that the lithium ion battery is abnormal when an occurrence frequency of the micro-short circuit becomes equal to or higher than a setting frequency for abnormality determination.

Patent Document 2, according to its abstract, states that a battery energy storage system is disclosed, the battery energy storage system comprising a rechargeable battery assembly for storing and providing energy and a protection system including an arc flash protection device to protect against risks due to arc flashes. The arc flash protection device comprises an overcurrent protection unit which detects overcurrent conditions indicating arc flash conditions in case of a low impedance of the battery assembly and an undervoltage protection unit which detects undervoltage conditions indicating arc flash conditions in case of a low impedance of the battery assembly, wherein upon detecting the overcurrent conditions and/or the undervoltage conditions for a predetermined minimum time period, the arc flash protection device initiates protective measures to prevent further operation of the battery assembly. An energy conversion system comprising such a battery energy storage system, which can be used for stationary and mobile energy supply or distribution applications, is also disclosed.

Patent Document 3, according to its abstract, states a lead battery comprising: a mono-block battery case having six cell chambers; an electrode group arranged in the cell chambers and infiltrated with an aqueous electrolyte; a reference electrode for referring to the potential of the electrolyte; and an electrically conductive member for connecting between the electrode group. A reference terminal RT connected to the reference electrode and a detection terminal DT for detecting the potentials of positive and negative electrodes connected to the electrically conductive member and constituting the electrode group are exposed on a battery lid covering the battery case.

Patent Document 4, according to its abstract, states a method for determining the ability or inability of a battery to supply a predetermined power level for a predetermined time. The method includes: a step of estimating the state of charge SOC of the battery; a step of measuring the temperature T of the battery; a step of determining, from the estimated state of charge SOC and the measured temperature T, the ability or inability of the battery by using an adaptive statistical model. The invention can be used in batteries for electric or hybrid vehicles.

### PRIOR ART DOCUMENT

### PATENT DOCUMENT

Patent Document 1: Japanese Patent Application Laid-Open No. 2003-009405
Patent Document 2: US 2015/244165 A1
Patent Document 3: JP 2019 050168 A
Patent Document 4: EP 3 092 144 B1

### SUMMARY OF THE INVENTION

### Problem to be solved by the invention

Conventionally, a use of lithium ion battery has been limited to technical fields such as notebook personal computers (PCs) and mobile phones, but in recent years, the lithium ion battery is expected to be used in various technical fields such as automobile including electric vehicles (EVs) and plug-in hybrid vehicles (PHVs), aircrafts, and power storage systems. For this reason, in recent years, development of a technique for detecting a failure of the lithium ion battery is more desired than ever before.

An object of the present invention is to provide a power supply device and a failure detection method for a battery capable of detecting a failure of the lithium ion battery.

### Means for solving the problem

According to a first aspect of the present disclosure, there is provided a power supply device as defined in independent claim 1.

In the first aspect, the peak detection unit may be a peak holding unit that holds at least one of the maximum value of the current and the minimum value of the voltage at the regular time intervals from at least one of the voltage and the current measured by the measurement unit.

In the first aspect, the measurement unit may measure the voltage and the current, the peak detection unit may detect the maximum value of the current and the minimum value of the voltage at the regular time intervals using the voltage and the current measured by the measurement unit, and the determination unit may determine the failure of the lithium ion battery based on the maximum value of the current and the minimum value of the voltage detected at regular time intervals by the peak detection unit.

In the first aspect, a temperature measurement unit that measures a temperature of the lithium ion battery may be further included, and the determination unit may determine the failure of the lithium ion battery based on at least one of the maximum value of the current and the minimum value of the voltage detected by the peak detection unit, at least one of the voltage and the current measured by the measurement unit, and the temperature measured by the temperature measurement unit.

In the first aspect, a temperature measurement unit that measures a temperature of the lithium ion battery may be further included, and the determination unit may determine the failure of the lithium ion battery based on the maximum value of the current and the minimum value of the voltage detected by the peak detection unit, the voltage and the current measured by the measurement unit, and the temperature measured by the temperature measurement unit.

In the first aspect, the determination unit may determine the failure of the lithium ion battery using a learned model using a neural network.

In the first aspect, the regular time interval may be 1 minute or less.

According to a second aspect of the present disclosure, there is provided a failure detection method as defined in independent claim 4.

### Advantageous effect of the invention

According to the present invention, it is possible to detect the failure of the lithium ion battery.

### BRIEF EXPLANATION OF DRAWINGS

FIG. 1 is a block diagram illustrating an example of a configuration of a power supply device according to one embodiment of the present invention.
FIG. 2 is a block diagram illustrating an example of a configuration of a data collection system.
FIG. 3 is a block diagram illustrating an example of a configuration of a data collection device.
FIG. 4 is a schematic diagram illustrating an example of data collected by a peak hold circuit.

### MODE FOR CARRYING OUT THE INVENTION

An embodiment of the present invention will be described in an order as below.
1. Configuration of power supply device
2. Failure detection method for battery
3. Data collection system
4. Data collection method
5. Learning
6. Preparation of power supply device on which a learned neural network is mounted
7. Action and effect
8. Modification Examples

### [1. Configuration of power supply device]

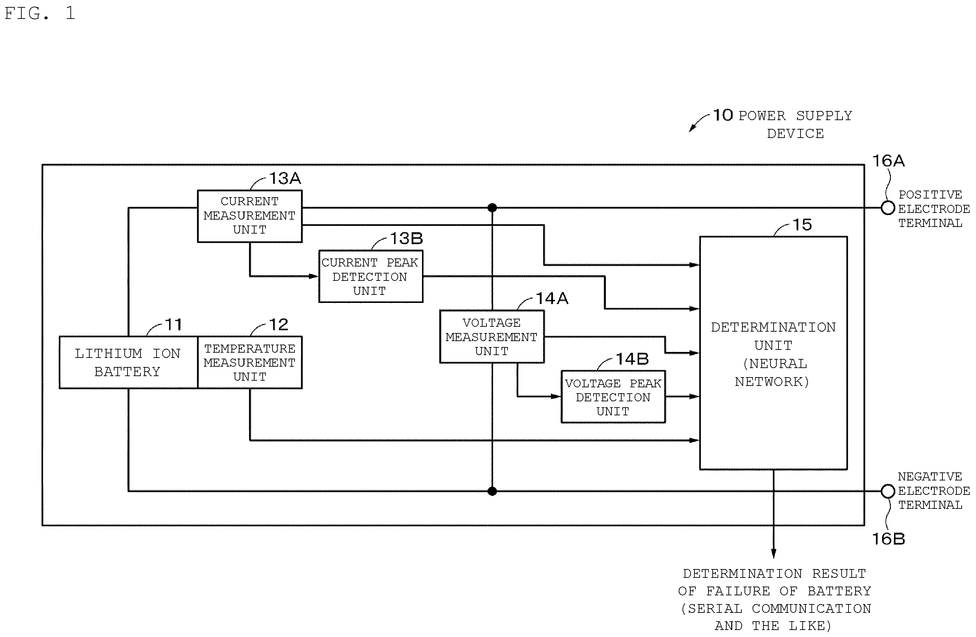

FIG. 1 is a block diagram illustrating an example of a configuration of a power supply device 10 according to one embodiment of the present invention. The power supply device 10 is a power supply device having the neural network realized by an information processing device. The power supply device 10 includes a secondary battery 11, a temperature measurement unit 12, a current measurement unit 13A, a current peak detection unit 13B, a voltage measurement unit 14A, a voltage peak detection unit 14B, a determination unit 15, a positive electrode terminal 16A, and a negative electrode terminal 16B. The power supply device 10 is preferably provided in electric vehicles (EV or PHV) or electric aircrafts.

The secondary battery 11 is a lithium ion battery. The positive electrode terminal of the secondary battery 11 is connected to the positive electrode terminal of a power supply source via the positive electrode terminal 16A. Furthermore, the negative electrode terminal of the secondary battery 11 is connected to the negative electrode terminal of the power supply source via the negative electrode terminal 16B.

The temperature measurement unit 12 includes a temperature detection element such as a thermocouple or a thermistor. The temperature detection element is disposed on or near a surface of the secondary battery 11. The temperature measurement unit 12 detects the temperature of the secondary battery 11 by the temperature detection element and outputs the temperature to the determination unit 15.

The current measurement unit 13A measures the current of the secondary battery 11 and outputs the current to the current peak detection unit 13B. The current measurement unit 13A is, for example, a current measurement circuit. The current peak detection unit 13B keeps the maximum value of the current at regular time intervals from the current measured by the current measurement unit 13A, and outputs the maximum value to the determination unit 15. The current peak detection unit 13B is an example of a current peak detection unit that detects the maximum value of the current at regular time intervals. As the current peak detection unit 13B, a current peak holding unit (the peak hold circuit) configured to be able to perform the peak hold for the maximum value of the current as an analog signal is used. From a viewpoint of early detection of the failure of the secondary battery 11, the regular time interval of the current holding is preferably 1 minute or less, more preferably 10 seconds or less, and still more preferably 1 second or less. A lower limit value of the regular time interval is not particularly limited, but is, for example, 10 milliseconds or more.

From the viewpoint of early detection of the failure of the secondary battery 11, the current peak detection unit 13B is preferably configured to be able to detect a current rise (the current peak) having a half-value width of 1 second or less. A detection target by the current peak detection unit 13B is the micro-short circuit derived from metal lithium. An instantaneous rise of the current of the secondary battery 11 and behavior of immediately recovering thereafter are characteristic behaviors observed in the micro-short circuit caused by a dendrite generation. The dendrite generation can be detected by detecting these characteristic behaviors (waveforms) by the current peak detection unit 13B. Accordingly, the determination unit 15 can determine whether the secondary battery 11 is normal or abnormal based on the maximum value of the current input from the current peak detection unit 13B.

The voltage measurement unit 14A measures the voltage of the secondary battery 11 and outputs the voltage to the voltage peak detection unit 14B. The voltage measurement unit 14A is, for example, a voltage measurement circuit. The voltage peak detection unit 14B holds the minimum value of the voltage at regular time intervals from the voltage measured by the voltage measurement unit 14A, and outputs the minimum value thereof to the determination unit 15. The voltage peak detection unit 14B is an example of a voltage peak detection unit that detects the minimum value of the voltage at regular time intervals. As the voltage peak detection unit 14B, a voltage peak holding unit (the peak hold circuit) configured to be able to perform the peak hold for the minimum value of the voltage as the analog signal is used. The regular time interval of voltage holding is preferably 1 minute or less, more preferably 10 seconds or less, and still more preferably 1 second or less from the viewpoint of early detection of the failure of the secondary battery 11. A lower limit value of the regular time interval is not particularly limited, but is, for example, 10 milliseconds or more.

From the viewpoint of early detection of the failure of the secondary battery 11, the voltage peak detection unit 14B is preferably configured to be able to detect a voltage drop (the voltage peak) having the half-value width of 1 second or less. The detection target by the voltage peak detection unit 14B is the micro-short circuit derived from metal lithium. An instantaneous drop of the voltage of the secondary battery 11 and behavior of immediately recovering thereafter are characteristic behaviors observed in the micro-short circuit caused by the dendrite generation. The dendrite generation can be detected by detecting these characteristic behaviors (the waveforms) by the voltage peak detection unit 14B. Accordingly, the determination unit 15 can determine whether the secondary battery 11 is normal or abnormal based on the minimum value of the voltage input from voltage peak detection unit 14B.

The determination unit 15 determines the failure of the secondary battery 11 based on the temperature measured by the temperature measurement unit 12, the current measured by the current measurement unit 13A, the voltage measured by the voltage measurement unit 14A, a maximum current value held by the current peak detection unit 13B, and a minimum voltage value held by the voltage peak detection unit 14B. The determination unit 15 is a processor that executes the above determination by the learned model using the neural network, or an integrated circuit such as an application specific integrated circuit (ASIC).

Specifically, the determination unit 15 includes a storage unit that stores the learned model using the neural network, and determines a failure of the secondary battery 11 using the learned model stored in the storage unit. The neural network includes an input layer and an output layer. Input data of the input layer is (1) the temperature measured by the temperature measurement unit 12, (2) the current measured by the current measurement unit 13A, (3) the voltage measured by the voltage measurement unit 14A, (4) the maximum current value held by the current peak detection unit 13B, and (5) the minimum voltage value held by the voltage peak detection unit 14B. Output data of the output layer is presence or absence of the failure of the secondary battery 11. The presence or absence of the failure of the secondary battery 11 is determined by inputting the data of (1) to (5) to the neural network. The storage unit included in the determination unit 15 is, for example, a nonvolatile memory.

### [2. Failure detection method for battery]

Hereinafter, an example of a failure detection method for battery using the power supply device 10 having the configuration above will be described.

To start with, the current measurement unit 13A and the voltage measurement unit 14A measure the voltage and the current of the secondary battery 11 respectively, and output the voltage and the current to the current peak detection unit 13B as well as the voltage peak detection unit 14B, and to the determination unit 15. In addition, the temperature measurement unit 12 measures the temperature of the secondary battery 11 and outputs the temperature to the determination unit 15.

Next, the current peak detection unit 13B holds the maximum value of the current at regular time intervals from the current measured by the current measurement unit 13A, and outputs the maximum value to the determination unit 15. In addition, the voltage peak detection unit 14B holds the minimum value of the voltage at regular time intervals from the voltage measured by the voltage measurement unit 14A, and outputs the minimum value thereof to the determination unit 15.

The determination unit 15 inputs, to the neural network, the temperature measured by the temperature measurement unit 12, the current measured by the current measurement unit 13A, the voltage measured by the voltage measurement unit 14A, the maximum current value held by the current peak detection unit 13B, and the minimum voltage value held by the voltage peak detection unit 14B as data to determine the presence or absence of the failure of the secondary battery 11, and outputs a determination result to an external device by, for example, serial communication.

### [3. Data collection system]

Hereinafter, an example of a configuration of a data collection system used for generating the learned model will be described.

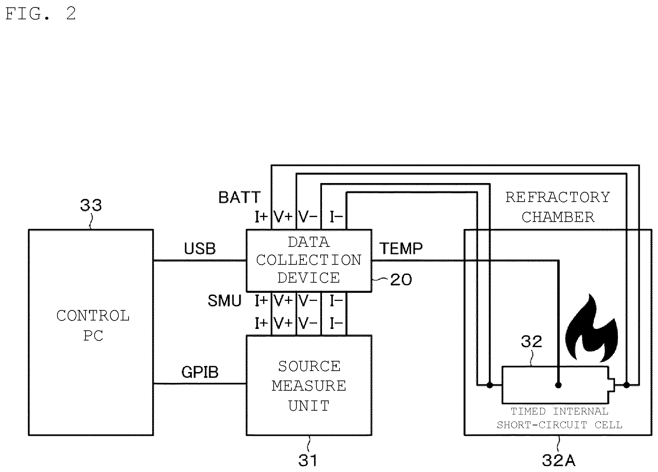

FIG. 2 is a block diagram illustrating an example of a configuration of a data collection system. The data collection system includes a data collection device 20, a source measure unit 31, a timed internal short-circuit cell 32, and a control PC 33. The data collection device 20 and the timed internal short-circuit cell 32 are connected by a cable. The data collection device 20 and the source measure unit 31 are connected by a cable. The control PC 33 and the data collection device 20 are connected by a cable such as a universal serial bus (USB). The control PC 33 and the source measure unit 31 are connected by a cable such as a general purpose interface bus (GPIB).

### (Timed internal short-circuit cell)

In an abnormality detection technique using machine learning, when only time series data in the normal time is used as teacher data, it is possible to determine as not normal, but it is not possible to determine whether it leads to a thermal runaway. In order to reliably determine that the thermal runaway occurs, it is necessary to prepare the time series data of a case where the thermal runaway occurs as the teacher data and to perform the learning using the data. Thereupon, the timed internal short-circuit cell 32 in which an internal short-circuit will soon occur is produced.

Furthermore, the timed internal short-circuit cell 32 is not obviously different from a commercially available lithium ion battery, but is a cell subjected to processing for causing an internal short-circuit at a predetermined intended timing. There are several preparation methods thereof, and a battery cell can be prepared by, for example, performing continuous charging, high temperature storage, overcharge cycle, or the like, or processing a short source inside the battery cell when assembling the battery cell. The timed internal short-circuit cell 32 is housed within a refractory chamber 32A.

### (Data collection device)

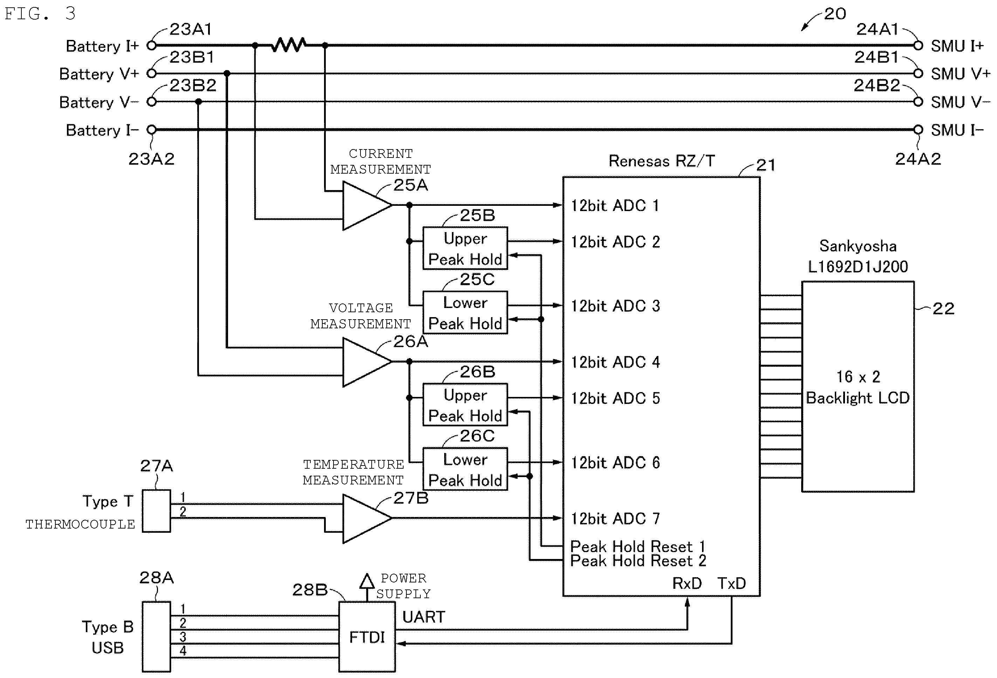

FIG. 3 is a block diagram illustrating an example of a configuration of the data collection device 20. The data collection device 20 measures a charge/discharge current, the voltage, and the temperature of the timed internal short-circuit cell 32. In addition, the data collection device 20 detects the minimum value and the maximum value of the current of the timed internal short-circuit cell 32 at regular time intervals and the minimum value and the maximum value of the voltage of the timed internal short-circuit cell 32 at regular time intervals.

The data collection device 20 includes a microcontroller 21 as a control device, a display device 22, positive electrode terminals 23A1, 24A1, 23B1, and 24B1, negative electrode terminals 23A2, 24A2, 23B2, and 24B2, a current measurement unit 25A, an upper peak hold circuit 25B, a lower peak hold circuit 25C, a voltage measurement unit 26A, an upper peak hold circuit 26B, a lower peak hold circuit 26C, a thermocouple 27A as a temperature detection element, a temperature measurement unit 27B, a USB connector 28A, and a USB serial converter 28B.

The positive electrode terminal 23A1 and the positive electrode terminal 24A1 are connected to each other. The negative electrode terminal 23A2 and the negative electrode terminal 24A2 are connected to each other. The positive electrode terminal 23A1 and the negative electrode terminal 23A2 are connected to a positive electrode terminal and a negative electrode terminal of the timed internal short-circuit cell 32 respectively, and the positive electrode terminal 24A1 and the negative electrode terminal 24A2 are connected to a positive electrode terminal and a negative electrode terminal for current control of the source measure unit 31 respectively.

The positive electrode terminal 23B1 and the positive electrode terminal 24B1 are connected to each other. The negative electrode terminal 23B2 and the negative electrode terminal 24B2 are connected to each other. The positive electrode terminal 23B1 and the negative electrode terminal 23B2 are connected to a positive electrode terminal and a negative electrode terminal of the timed internal short-circuit cell 32 respectively, and the positive electrode terminal 24B1 and the negative electrode terminal 24B2 are connected to a positive electrode terminal and a negative electrode terminal for a voltage control of the source measure unit 31 respectively.

The current measurement unit 25A measures a current flowing between the positive electrode terminal 23A1 and the positive electrode terminal 24A1, and outputs the current to the upper peak hold circuit 25B, the lower peak hold circuit 25C, and the microcontroller 21. The upper peak hold circuit 25B holds the maximum current value at regular time intervals from the current measured by the current measurement unit 25A, and outputs the maximum current value to the microcontroller 21. The lower peak hold circuit 25C holds a minimum current value at regular time intervals from the current measured by the current measurement unit 25A, and outputs the minimum current value to the microcontroller 21.

The voltage measurement unit 26A measures a voltage applied between the positive electrode terminal 23B1 and the negative electrode terminal 23B2, and outputs the voltage to the upper peak hold circuit 26B, the lower peak hold circuit 26C, and the microcontroller 21. The upper peak hold circuit 26B holds a maximum voltage value at regular time intervals from the voltage measured by the voltage measurement unit 26A, and outputs the maximum voltage value to the microcontroller 21. The lower peak hold circuit 25C holds the minimum voltage value at regular time intervals from the voltage measured by the voltage measurement unit 26A, and outputs the minimum voltage value to the microcontroller 21.

The thermocouple 27A is disposed on or near a surface of the timed internal short-circuit cell 32. The temperature measurement unit 27B measures the temperature of the timed internal short-circuit cell 32 by the thermocouple 27A and outputs the temperature to the microcontroller 21.

A USB connector 28A is connected to the microcontroller 21 via a USB serial converter 28B. A USB cable is connected to the USB connector 28A. The data collection device 20 and the control PC 33 are connected via the USB cable.

The microcontroller 21 acquires a voltage, a current, a temperature, a minimum voltage value at regular time intervals, the maximum voltage value at regular time intervals, the minimum current value at regular time intervals, and the maximum current value at regular time intervals, and outputs the acquired values to the control PC 33. The microcontroller 21 resets each of the upper peak hold circuits 25B and 26B and the lower peak hold circuits 25C and 26C at regular time intervals. Accordingly, it is possible to read the minimum current value, the maximum current value, the minimum voltage value, and the maximum voltage value at a regular period after a previous reset. The display device 22 displays information related to collected data and the like.

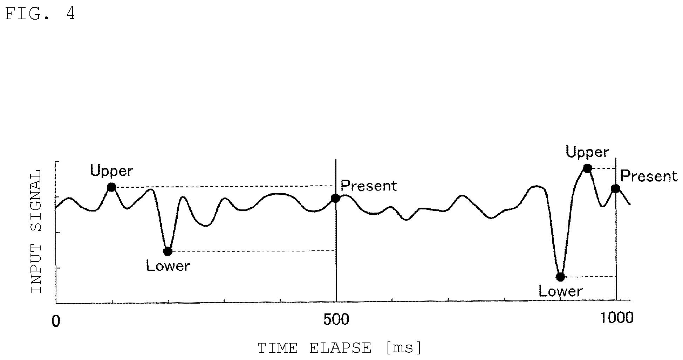

The data collection device 20 is configured to be able to measure, for example, a peak value of a peak having a half-value width of 1 µs or more with an accuracy of 5% or less. The data collection device 20 is equipped with a continuous data transmission function. This is a function of transmitting (1) the value (Present) at that time, (2) the maximum value (Upper) in the latest 500 milliseconds, and (3) the minimum value (Lower) at regular time intervals (for example, every 500 milliseconds) (see FIG. 4).

### (Source measure unit)

The source measure unit 31 charges and discharges the timed internal short-circuit cell 32.

### (Control PC)

The control PC 33 controls the source measure unit 31 to charge and discharge the timed internal short-circuit cell 32. Furthermore, the control PC 33 controls the data collection device 20 to collect data on the timed internal short-circuit cell 32.

### [4. Data collection method]

Hereinafter, an example of a data collection method using the data collection system having the configuration above will be described.

The control PC 33 controls the source measure unit 31 to perform a cycle test of the timed internal short-circuit cell 32. Charge conditions in the cycle test are, for example, 1C charge, and discharge conditions are, for example, a current pattern actually applied to the battery in the electric aircrafts. Then, the data collection device 20 measures time-series data of the current, the voltage, the temperature, the minimum current value, the maximum current value, the minimum voltage value, and the maximum voltage value until the timed internal short-circuit cell 32 reaches the thermal runaway. The control PC 33 collects the time-series data measured by the data collection device 20. This charge-discharge cycle test is performed until the timed internal short-circuit cell 32 undergoes an exothermic runaway. This series of data collection is performed using, for example, 200 timed internal short-circuit cells 32.

### [5. Learning]

The time series data of the current, the voltage, the temperature, the minimum current value, the maximum current value, the minimum voltage value, and the maximum voltage value collected by the data collection device 20 is used as the teacher data by using a machine learning platform TensorFlow to create a neural network for abnormality detection.

### [6. Preparation of power supply device on which the learned neural network is mounted]

A neural network created on TensorFlow using Renesas integrated development environment e2 studio is converted into a source code for a microprocessor, and the source code is written into the microprocessor. Then, in combination with the current measurement unit 13A, the current peak detection unit 13B, the voltage measurement unit 14A, the voltage peak detection unit 14B, and the temperature measurement unit 12, the power supply device 10 (see FIG. 1) on which the learned neural network is mounted is prepared.

The power supply device 10 is configured to be able to output (1) how many seconds after which an abnormality occurs and (2) the percentage of certainty of the abnormality.

For example, specifically when a data acquisition interval of the power supply device 10 is every 500 milliseconds, in a case where the current peak detection unit 13B and the voltage peak detection unit 14B capable of detecting the peak value of the peak having the half-value width of 1 µs or more are provided, the current abnormality and the voltage abnormality can be detected in an early stage.

In learning and estimation of the neural network, not only voltage but also current and temperature information are used. Since a voltage waveform for determining the presence or absence of the failure of the secondary battery 11 depends on an internal resistance, and the internal resistance depends on the current and the temperature, more accurate determination can be made by using these three physical quantities.

### [7. Action and effect]

It is possible to determine whether the battery is normal or abnormal by detecting an instantaneous voltage drop and a voltage behavior that recovers immediately thereafter. However, in the technique described in Patent Document 1, particularly when a lithium ion battery is to be used as a battery for the electric aircrafts, there are two insufficient points: (1) a specific detection means for detecting a voltage waveform thereof; and (2) a specific determination means for determining an obtained waveform.

### (1) With respect to detection means

Regarding the instantaneous voltage drop caused by the dendrite generation and the voltage behavior that immediately recovers thereafter, paragraph 0045 of Patent Document 1 describes that voltage measurement is performed every several tens of milliseconds.

However, specifically when the interval of the voltage measurement is every several tens of milliseconds, it cannot be said that the interval is sufficiently fast. This is because, in the internal short circuit caused by the dendrite, to start with, an extremely thin dendrite is connected between the positive and negative electrodes to cause an internal short circuit, which fuses in an extremely short time, then a slightly thick dendrite is connected between the positive and negative electrodes to cause an internal short circuit, which fuses after a slightly long short circuit time, and then a slightly thicker dendrite is connected, so that the dendrite gradually becomes thicker, and the short circuit time gradually becomes longer. In other words, an earlier dendrite growth can be found, the more it is possible to measure the initial abnormal voltage behavior in an extremely short time. At a measurement interval of several tens of milliseconds, it is difficult to detect such initial dendrite generation, and when the dendrite generation can be detected, there is not much time left until the thermal runaway, and the dendrite generation is detected after a relatively late stage. How much time is needed depends on a use application of the battery. For example, in a battery for electric aircrafts, a time on an order of several tens of minutes at the minimum and a time on an order of several hours when possible are needed as a postponed time from the detection of the internal short circuit to a safe landing of the aircrafts. The measurement interval of every several tens of milliseconds was insufficient for such applications that particularly has high requirement for safety.

In order to be able to measure a high-speed current change and a voltage change that are much shorter than several tens of milliseconds, for example, there is a method of increasing a sampling frequency of an AD converter that reads current behavior and voltage behavior. However, attempting to perform high-speed sampling on a large number of batteries required to drive an electric aircraft would increase an overall cost of the system. In Patent Document 1, the detection means for preventing the increase in cost is not sufficiently devised.

On the other hand, the power supply device 10 according to one embodiment includes the current peak detection unit 13B and the voltage peak detection unit 14B in order to solve the problem above. The current peak detection unit 13B and the voltage peak detection unit 14B are circuits that continue to hold the maximum value and the minimum value at a regular time interval. Accordingly, this makes it possible to detect the minimum voltage value without increasing the sampling frequency of the AD converter specifically when the current rise or the voltage drop has a very narrow half-value width.

The current peak detection unit 13B configured by a first peak hold circuit and the voltage peak detection unit 14B configured by the second peak hold circuit can be relatively easily constructed by an analog circuit using a rectifier element, and the cost of the circuit can also be suppressed. This is particularly effective in a case where a large number of batteries such as in the electric aircrafts are used.

### (2) With respect to determination means

Next is a base voltage. Patent Document 1 describes a threshold voltage for determining that the detection value of the voltage detection unit has instantaneously dropped. However, a degree of a voltage minimal value of the voltage drop due to the micro-short circuit depends on the internal resistance of the battery, and the internal resistance depends on the degree of deterioration, the temperature, and the like. Therefore, when the base voltage is used as a determination reference, it is necessary to separately prepare a measurement means of the internal resistance of the battery and the like, and sequentially change the base voltage using an obtained internal resistance value. However, in Patent Document 1, such discussion is not sufficiently made, and a scientific basis for determination criteria is insufficient.

On the other hand, in the power supply device 10 according to one embodiment, a neural network is used to solve the above problems. When the neural network is learned, not only voltage information but also current and temperature information are used. The internal resistance of the battery is a physical quantity dependent on the voltage, the current, and the temperature. Therefore, by using these three pieces of data for learning and estimation, more accurate determination based on the internal resistance can be made.

The data used for learning and estimation of the neural network is not limited to the three pieces of data of the voltage, the current, and the temperature. Data obtained by the current peak detection unit 13B and the voltage peak detection unit 14B is also used as information on the voltage rise and the voltage drop having a very narrow half-value width. Accordingly, a determination accuracy can be further improved.

### [8. Modification examples]

### (First modification example)

In the embodiment described above, the power supply device 10 may not include the temperature measurement unit 12. In this case, the data collection device 20 may not include the thermocouple 27A and the temperature measurement unit 27B.

### (Second modification example)

In the embodiment described above, the power supply device 10 may not include the current measurement unit 13A and the current peak detection unit 13B. In this case, the data collection device 20 may not include the current measurement unit 25A, the upper peak hold circuit 25B, and the lower peak hold circuit 25C.

### (Third modification example)

In the embodiment described above, the power supply device 10 may not include the voltage measurement unit 14A and the voltage peak detection unit 14B. In this case, the data collection device 20 may not include the voltage measurement unit 26A, the upper peak hold circuit 26B, and the lower peak hold circuit 26C.

### (Fourth modification example)

In the embodiment described above, an example in which the power supply device 10 includes one secondary battery 11 and the data collection system includes one timed internal short-circuit cell 32 has been described. However, the power supply device 10 may include a plurality of secondary batteries 11 and the data collection system may include a plurality of timed internal short-circuit cells 32. In this case, the current measurement unit 13A of the power supply device 10 may measure the currents of the plurality of secondary batteries 11 connected, and the voltage measurement unit 14A of the power supply device 10 may measure the voltage of each secondary battery 11. In addition, the current measurement unit 25A of the data collection device 20 may measure the currents of the plurality of timed internal short-circuit cells 32 connected, and the voltage measurement unit 26A of the data collection device 20 may measure the voltage of each timed internal short-circuit cell 32.

### (Fifth modification example)

In the embodiment described above, an example in which the power supply device 10 includes the current measurement unit 13A, the current peak detection unit 13B, the voltage measurement unit 14A, and the voltage peak detection unit 14B has been described. However, the sampling frequency of the AD converter that reads the current behavior and the voltage behavior may be increased to detect the maximum current value and the minimum voltage value.

Although the embodiment and the modification examples of the present invention have been specifically described above, the present invention is not limited to the embodiment and modification examples above, and various modifications based on the technical idea of the present invention can be made within the scope of the appended claims.

For example, the configurations, methods, steps, shapes, materials, numerical values, and the like described in the embodiment and modification examples described above are merely examples, and different configurations, methods, steps, shapes, materials, numerical values, and the like may be used as necessary.

In addition, the configurations, methods, steps, shapes, materials, numerical values, and the like of the embodiment and modification examples described above can be combined with each other without departing from the scope of the present invention as defined by the appended claims.

### DESCRIPTION OF REFERENCE SYMBOLS

10: Power supply device
11: Secondary battery
12, 27B: Temperature measurement unit
13A, 25A: Current measurement unit
13B: Current peak detection unit
14A, 26A: Voltage measurement unit
14B: Voltage peak detection unit
15: Determination unit
16A, 23A1, 23B1, 24A1, 24B1: Positive electrode terminal
16B, 23A2, 23B2, 24A2, 24B2: Negative electrode terminal
20: Data collection device
21: Microcontroller
22: Display device
25B, 26B: Upper peak hold circuit
25C, 26C: Lower peak hold circuit
27A: Thermocouple
28A: USB connector
28B: USB serial converter
31: Source measure unit
32: Timed internal short-circuit cell
32A: Refractory chamber
33: Control PC

## Claims

1. A power supply device (10) comprising:
a measurement unit (13A, 14A, 25A, 26A) configured to measure a voltage and a current of a lithium ion battery (11) ;
a peak detection unit (13B, 14B) configured to detect a maximum value of the current and a minimum value of the voltage at regular time intervals using the voltage and the current measured by the measurement unit (13A, 14A, 25A, 26A) ;
a temperature measurement unit (12, 27B) configured to measure a temperature of the lithium ion battery (11); and
a determination unit (15) configured to determine a failure of the lithium ion battery (11) based on the maximum value of the current and the minimum value of the voltage detected at the regular time intervals by the peak detection unit (13B, 14B), the voltage and the current measured by the measurement unit (13A, 14A, 25A, 26A), and the temperature measured by the temperature measurement unit (12, 27B); and
wherein the determination unit (15) is configured to determine the failure of the lithium ion battery (11) using a learned model using a neural network,
wherein the determination unit (15) is configured to input, to the neural network, the temperature measured by the temperature measurement unit (12), the current measured by the current measurement unit (13A), the voltage measured by the voltage measurement unit (14A), the maximum current value held by the current peak detection unit (13B), and the minimum voltage value held by the voltage peak detection unit (14B) as data to determine presence or absence of the failure of the secondary battery (11).

2. The power supply device (10) according to claim 1, wherein the peak detection unit (13B, 14B) is a peak holding unit that holds the maximum value of the current and the minimum value of the voltage at the regular time intervals from the voltage and the current measured by the measurement unit (13A, 14A, 25A, 26A).

3. The power supply device (10) according to claim 1 or 2, wherein each of the regular time intervals is 1 minute or less.

4. A failure detection method for a battery, comprising:
measuring a voltage and a current of a lithium ion battery (11);
detecting a maximum value of the current and a minimum value of the voltage at regular time intervals using the measured voltage and the measured current;
measuring a temperature of the lithium ion battery (11); and
determining the failure of the lithium ion battery (11) based on the maximum value of the current and the minimum value of the voltage detected at regular time intervals, the measured voltage and the measured current, and the measured temperature, wherein the failure of the lithium ion battery (11) is determined using a learned model using a neural network; and
inputting, to the neural network, the temperature measured by the temperature measurement unit (12), the current measured by the current measurement unit (13A), the voltage measured by the voltage measurement unit (14A), the maximum current value held by the current peak detection unit (13B), and the minimum voltage value held by the voltage peak detection unit (14B) as data to determine the presence or absence of the failure of the secondary battery (11) .

## Patentansprüche

1. Stromversorgungsvorrichtung (10), aufweisend:
eine Messeinheit (13A, 14A, 25A, 26A), die dazu konfiguriert ist, eine Spannung und einen Strom einer Lithium-Ionen-Batterie (11) zu messen;
eine Peak-Detektionseinheit (13B, 14B), die dazu konfiguriert ist, einen Maximalwert des Stroms und einen Minimalwert der Spannung in regelmäßigen Zeitintervallen unter Verwendung der Spannung und des Stroms, die von der Messeinheit (13A, 14A, 25A, 26A) gemessen werden, zu detektieren;
eine Temperaturmesseinheit (12, 27B), die dazu konfiguriert ist, eine Temperatur der Lithium-Ionen-Batterie (11) zu messen; und
eine Bestimmungseinheit (15), die dazu konfiguriert ist, einen Fehler der Lithium-Ionen-Batterie (11) basierend auf dem Maximalwert des Stroms und dem Minimalwert der Spannung, die in den regelmäßigen Zeitintervallen von der Peak-Detektionseinheit (13B, 14B) detektiert werden, der Spannung und dem Strom, die von der Messeinheit (13A, 14A, 25A, 26A) gemessen werden, und der Temperatur, die von der Temperaturmesseinheit (12, 27B) gemessen wird, zu bestimmen; und
wobei die Bestimmungseinheit (15) dazu konfiguriert ist, den Fehler der Lithium-Ionen-Batterie (11) unter Verwendung eines gelernten Modells unter Verwendung eines neuronalen Netzes zu bestimmen,
wobei die Bestimmungseinheit (15) dazu konfiguriert ist, in das neuronale Netz die von der Temperaturmesseinheit (12) gemessene Temperatur, den von der Strommesseinheit (13A) gemessenen Strom, die von der Spannungsmesseinheit (14A) gemessene Spannung, den von der Strom-Peak-Detektionseinheit (13B) gehaltenen maximalen Stromwert und den von der Spannungs-Peak-Detektionseinheit (14B) gehaltenen minimalen Spannungswert als Daten einzugeben, um das Vorhandensein oder Nichtvorhandensein des Fehlers der Sekundärbatterie (11) zu bestimmen.

2. Stromversorgungsvorrichtung (10) nach Anspruch 1, wobei die Peak-Detektionseinheit (13B, 14B) eine Peak-Halteeinheit ist, die den Maximalwert des Stroms und den Minimalwert der Spannung in den regelmäßigen Zeitintervallen von der Spannung und dem Strom hält, die von der Messeinheit (13A, 14A, 25A, 26A) gemessen werden.

3. Stromversorgungsvorrichtung (10) nach Anspruch 1 oder 2, wobei jedes der regelmäßigen Zeitintervalle 1 Minute oder weniger beträgt.

4. Fehlerdetektionsverfahren für eine Batterie, aufweisend:
Messen einer Spannung und eines Stroms einer Lithium-Ionen-Batterie (11);
Detektieren eines Maximalwerts des Stroms und eines Minimalwerts der Spannung in regelmäßigen Zeitintervallen unter Verwendung der gemessenen Spannung und des gemessenen Stroms;
Messen einer Temperatur der Lithium-Ionen-Batterie (11); und
Bestimmen des Fehlers der Lithium-Ionen-Batterie (11) basierend auf dem Maximalwert des Stroms und dem Minimalwert der Spannung, die in regelmäßigen Zeitintervallen detektiert werden, der gemessenen Spannung und dem gemessenen Strom und der gemessenen Temperatur, wobei der Fehler der Lithium-Ionen-Batterie (11) unter Verwendung eines gelernten Modells unter Verwendung eines neuronalen Netzes bestimmt wird; und
Eingeben der von der Temperaturmesseinheit (12) gemessenen Temperatur, des von der Strommesseinheit (13A) gemessenen Stroms, der von der Spannungsmesseinheit (14A) gemessenen Spannung, des von der Strom-Peak-Detektionseinheit (13B) gehaltenen maximalen Stromwerts und des von der Spannungs-Peak-Detektionseinheit (14B) gehaltenen minimalen Spannungswerts als Daten in das neuronale Netz, um das Vorhandensein oder Nichtvorhandensein des Fehlers der Sekundärbatterie (11) zu bestimmen.

## Revendications

1. Dispositif d'alimentation électrique (10) comprenant :
une unité de mesure (13A, 14A, 25A, 26A) configurée pour mesurer une tension et un courant d'une batterie au lithium-ion (11) ;
une unité de détection de crête (13B, 14B) configurée pour détecter une valeur maximale du courant et une valeur minimale de la tension à des intervalles de temps réguliers à l'aide de la tension et du courant mesurés par l'unité de mesure (13A, 14A, 25A, 26A) ;
une unité de mesure de température (12, 27B) configurée pour mesurer une température de la batterie au lithium-ion (11) ; et
une unité de détermination (15) configurée pour déterminer une défaillance de la batterie au lithium-ion (11), sur la base de la valeur maximale du courant et de la valeur minimale de la tension détectées aux intervalles de temps réguliers par l'unité de détection de crête (13B, 14B), de la tension et du courant mesurés par l'unité de mesure (13A, 14A, 25A, 26A), et de la température mesurée par l'unité de mesure de température (12, 27B) ; et
dans lequel l'unité de détermination (15) est configurée pour déterminer la défaillance de la batterie au lithium-ion (11) à l'aide d'un modèle appris utilisant un réseau neuronal,
dans lequel l'unité de détermination (15) est configurée pour entrer, dans le réseau neuronal, la température mesurée par l'unité de mesure de température (12), le courant mesuré par l'unité de mesure de courant (13A), la tension mesurée par l'unité de mesure de tension (14A), la valeur de courant maximale maintenue par l'unité de détection de crête de courant (13B) et la valeur de tension minimale maintenue par l'unité de détection de crête de tension (14B) en tant que données pour déterminer une présence ou une absence de la défaillance de l'accumulateur (11).

2. Dispositif d'alimentation électrique (10) selon la revendication 1, dans lequel l'unité de détection de crête (13B, 14B) est une unité de maintien de crête qui maintient la valeur maximale du courant et la valeur minimale de la tension à des intervalles de temps réguliers à partir de la tension et du courant mesurés par l'unité de mesure (13A, 14A, 25A, 26A).

3. Dispositif d'alimentation électrique (10) selon la revendication 1 ou 2, dans lequel chacun des intervalles de temps réguliers est de 1 minute ou moins.

4. Procédé de détection de défaillance pour une batterie, comprenant :
la mesure d'une tension et d'un courant d'une batterie au lithium-ion (11) ;
la détection d'une valeur maximale du courant et d'une valeur minimale de la tension à des intervalles de temps réguliers à l'aide de la tension mesurée et du courant mesuré ;
la mesure d'une température de la batterie au lithium-ion (11) ; et
la détermination de la défaillance de la batterie au lithium-ion (11) sur la base de la valeur maximale du courant et de la valeur minimale de la tension détectées à des intervalles de temps réguliers, de la tension mesurée et du courant mesuré, et de la température mesurée, dans lequel la défaillance de la batterie au lithium-ion (11) est déterminée à l'aide d'un modèle appris utilisant un réseau neuronal ; et
l'entrée, dans le réseau neuronal, de la température mesurée par l'unité de mesure de température (12), du courant mesuré par l'unité de mesure de courant (13A), de la tension mesurée par l'unité de mesure de tension (14A), de la valeur de courant maximale maintenue par l'unité de détection de crête de courant (13B) et de la valeur de tension minimale maintenue par l'unité de détection de crête de tension (14B) en tant que données pour déterminer la présence ou l'absence de la défaillance de l'accumulateur (11).
